Europäisches Patentamt

European Patent Office

Office européen des brevets

(19)

(11) **EP 0 448 465 B1**

(12) **FASCICULE DE BREVET EUROPEEN**

(45) Date de publication et mention
de la délivrance du brevet:
**29.05.1996 Bulletin 1996/22**

(51) Int Cl.⁶: **H01L 31/101**, H01L 31/108

(21) Numéro de dépôt: **91400751.3**

(22) Date de dépôt: **20.03.1991**

(54) **Procédé de détection optique à seuil de détection variable**

Optisches Detektionsverfahren mit verstellbarer Detektionsschwelle

Optical Detection Method with Variable Detection Threshold

(84) Etats contractants désignés:
**DE FR GB**

(30) Priorité: **22.03.1990 FR 9003668**

(43) Date de publication de la demande:
**25.09.1991 Bulletin 1991/39**

(73) Titulaire: **FRANCE TELECOM
F-92131 Issy les Moulineaux (FR)**

(72) Inventeurs:
- **Badoz, Pierre Antoine
  F-38000 Grenoble (FR)**
- **Duboz, Jean-Yves
  F-39100 Dole (FR)**

(74) Mandataire: **Poulin, Gérard et al
Société BREVATOME
25, rue de Ponthieu
75008 Paris (FR)**

(56) Documents cités:
**EP-A- 0 007 878**          **US-A- 4 908 686**

- **JOURNAL OF THE OPTICAL SOCIETY OF AMERICA. vol. 70, no. 6, juin 1980, NEW YORK US pages 631 - 632; J.M.PINTI GUEDES ET AL.: "PICOSECOND THIN-FILM METAL-SEMICONDUCTOR-METAL PHOTODETECTORS"**
- **IEEE JOURNAL OF QUANTUM ELECTRONICS. vol. QE14, no. 3, mars 1978, NEW YORK US**
- **pages 159 - 169; M.HEIBLUM ET AL.: "CHARACTERISTICS OF INTEGRATED MOM JUNCTIONS AT DC AND AT OPTICAL FREQUENCIES"**
- **APPLIED PHYSICS LETTERS. vol. 51, no. 4, 27 juillet 1987, NEW YORK US pages 267 - 269; B.M.DITCHEK ET AL.: "NOVEL HIGH QUANTUM EFFICIENCY Si-TaSi2 EUTECTIC PHOTODIODES"**
- **IEEE JOURNAL OF QUANTUM ELECTRONICS, Vol. QE-15, No.6, Juin 1979, pages 475-481**

## Description

La présente invention concerne un procédé de détection optique.

Il s'applique notamment à la détection de rayonnements infrarouges.

On connaît déjà des dispositifs de détection optique permettant de détecter des rayonnements lumineux appartenant au domaine du proche infrarouge.

De tels dispositifs sont par exemple mentionnés dans les documents suivants :

- Article de W.F. KOSONOCKY et al., publié dans Proceedings of the 14th Conference (1982 International) on Solid State Devices, Tokyo 1982, Japanese Journal of Applied Physics, vol.22 (1983) Supplement 22-1, pp.103-108
- Article de BOR-YEU TSAUR et al., publié dans IEEE Electron Device Letters, vol.9, n°12, décembre 1988, pp.650-653
- Article de BOR-YEU TSAUR et al., publié dans IEEE Electron Device Letters, vol.10, n°8, août 1989, pp.361-363.

Ces dispositifs connus sont des diodes SCHOTTKY qui comprennent une couche métallique mince, dont l'épaisseur est de l'ordre de 10nm, déposée sur un substrat semiconducteur.

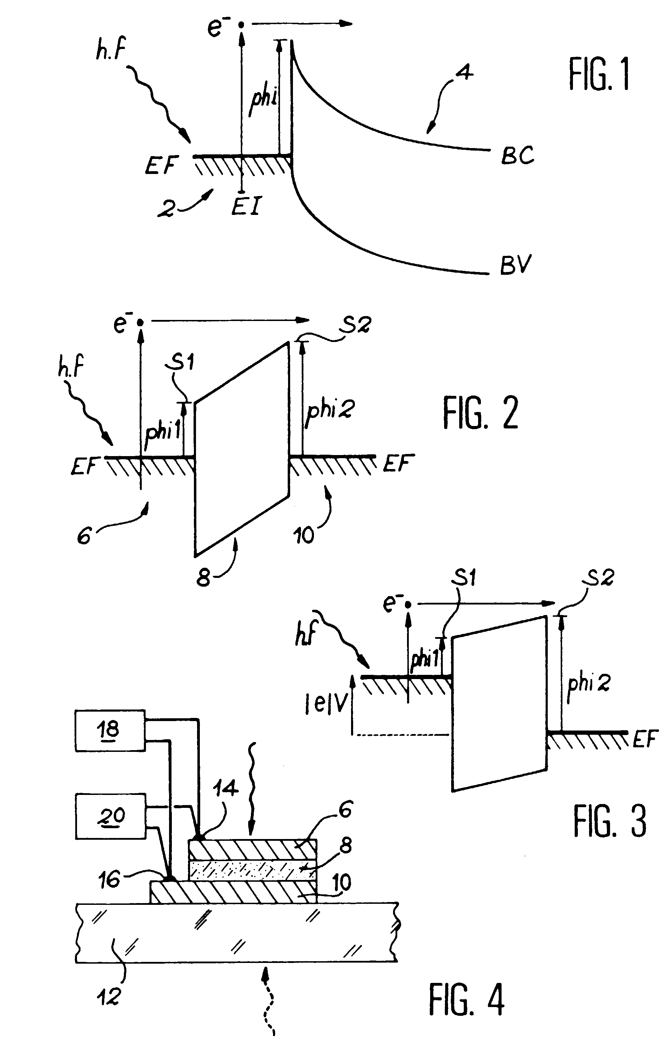

Le principe de la détection optique au moyen d'une diode SCHOTTKY est schématiquement illustré par la figure 1 sur laquelle on voit la jonction entre la couche métallique 2, dont le niveau de FERMI est noté EF, et le substrat semiconducteur 4 dont la bande de valence et la bande de conduction sont respectivement notées BV et BC.

Le principe de la détection optique dans cette diode SCHOTTKY est le suivant : le rayonnement lumineux incident, constitué de photons d'énergie h.f, est absorbé par les électrons de la couche métallique 2, h étant la constante de PLANCK et f étant la fréquence des photons.

Un électron $e^-$ ayant absorbé un photon possède alors une énergie égale à la somme de l'énergie El qu'il avait avant absorption du photon et de l'énergie h.f du photon qu'il a absorbé.

Si cette somme est supérieure à la hauteur phi de la barrière de potentiel qui existe à l'interface entre la couche métallique et le substrat semiconducteur, cet électron excité est susceptible de franchir la barrière de potentiel pour être collecté par le substrat semiconducteur.

Il se produit ainsi une photo-émission interne d'électrons de la couche métallique vers le substrat semiconducteur.

Cette photo-émission interne provoque le passage d'un photo-courant qui peut alors être amplifié et détecté.

La gamme d'énergie du rayonnenent détecté est limitée inférieurement par la hauteur phi de la barrière SCHOTTKY de la diode, hauteur qui est égale à la différence entre le bas de la bande de conduction BC du substrat semiconducteur et le niveau de FERMI EF de la couche métallique.

Cette hauteur de la barrière est déterminée par le couple (métal, semiconducteur) choisi.

Pour le silicium de type N par exemple, la hauteur de la barrière va d'environ 0,3 eV à 0,95 eV suivant le métal choisi.

De plus, la hauteur de la barrière de potentiel est quasiment indépendante de la tension appliquée entre les bornes de la diode, une très faible variation de phi, de quelques dizaines de meV au maximum, pouvant néanmoins être obtenue par l'application d'une tension de plusieurs volts à la diode (effet SCHOTTKY).

De ce fait, en pratique, le spectre du rayonnement détecté et en particulier le seuil de détection optique (énergie minimale ou longueur d'onde maximale détectée) sont fixés pour une diode donnée et on ne peut les faire varier.

La présente invention a pour but de remédier à ces inconvénients en proposant un procédé de détection optique selon lequel on peut faire varier de façon très importante le spectre de détection (jusqu'à plusieurs centaines de meV) par application d'une tension électrique qui, dans certaines réalisations particulières, ne dépasse pas 1V.

Pour ce faire, la présente invention utilise une structure de type conducteur/semiconducteur/ conducteur ou conducteur/isolant/conducteur, par exemple une structure de type métal/semiconducteur/ métal.

On connaît par l'article de J.M. PINTO GUEDES et al. publié dans Journal of the Optical Society of America, vol. 70, n° 6, juin 1980, pages 631-632, un photodétecteur dont la structure est du type métal-semiconducteur-métal; le semiconducteur peut être une couche mince de ZnO.

Une structure photoconductrice du type métal-isolant-métal est décrite dans l'article des mêmes auteurs publié dans IEEE Journal of Quantum Electronics, Vol. QE-15, no. 6, juin 1979, pages 475-481.

La présente invention a pour objet un procédé de détection optique, conforme à la revendication 1.

Chacune des deux couches conductrices du dispositif utilisé peut être, par exemple, une couche métallique ou une couche semiconductrice suffisamment dopée.

On dispose ainsi d'un dispositif de détection optique multispectral, c'est-à-dire d'un dispositif de détection dont on peut faire varier le spectre de détection et également le seuil de détection (ou, en d'autres termes, la fréquence de coupure), par application d'une tension électrique variable entre les deux couches conductrices.

Selon un premier mode de réalisation particulier du dispositif, les couches conductrices sont choisies de façon que les hauteurs des barrières de potentiel qui leur correspondent soient différentes l'une de l'autre.

Il est alors possible de faire varier le seuil de détection du dispositif au moyen d'une faible tension électrique, ne dépassant pas 1V.

De plus, ce seuil de détection varie alors de façon quasiment linéaire avec la tension appliquée et ce, sur la plus grande partie du spectre disponible.

Dans le cas du premier mode de réalisation particulier, le substrat peut être transparent ou du moins partiellement transparent au rayonnement.

Ceci permet d'utiliser le dispositif en l'orientant de façon que le rayonnement arrive sur l'hétérostructure en traversant le substrat.

En variante, le substrat du dispositif peut être opaque au rayonnement. Dans ce cas, le dispositif est orienté de façon que le rayonnement arrive directement sur l'hétérostructure.

Selon un deuxième mode de réalisation particulier du dispositif, les couches conductrices sont choisies de façon que les hauteurs des barrières de potentiel qui leur correspondent soient sensiblement égales l'une à l'autre.

Dans ce cas, on peut aussi utiliser un substrat qui est opaque au rayonnement ou qui est transparent, ou partiellement transparent, à ce rayonnement.

Dans le deuxième mode de réalisation particulier, on peut bien entendu utiliser deux couches conductrices qui sont faites du même matériau électriquement conducteur.

Dans le dispositif , le substrat peut être en silicium.

Ceci permet de réaliser également sur ce substrat un circuit électronique de commande et/ou d'amplification pour le dispositif.

Enfin, dans une réalisation particulière du dispositif, les deux couches conductrices sont respectivement en disiliciure d'erbium et en disiliciure de cobalt, la couche intermédiaire est en siliciun et le substrat est également en silicium.

La présente invention sera mieux comprise à la lecture de la description d'exemples de réalisation donnés ci-après à titre purement indicatif et nullement limitatif, en référence aux dessins annexés sur lesquels :

- la figure 1, déjà décrite, représente le diagramme de bande simplifié d'une diode SCHOTTKY et, de façon schématique, la photo-émission interne d'un électron de la couche métallique de la diode par absorption d'un photon incident,
- la figure 2 illustre le fonctionnement d'un dispositif approprié à l'invention, à hétérostructure asymétrique, au moyen du diagramme de bande simplifié de cette hétérostructure, en l'absence de polarisation du dispositif,
- la figure 3 représente le diagramme de bande simplifié de cette hétérostructure asymétrique lorsque le dispositif est polarisé,
- la figure 4 est une vue schématique d'un dispositif de détection optique approprié à l'invention,

- la figure 5 illustre le fonctionnement d'un autre dispositif approprié à l'invention, à hétérostructure symétrique, au moyen du diagramme de bande simplifié de cette hétérostructure symétrique, en l'absence de polarisation du dispositif,
- la figure 6 représente le diagramme de bande simplifié de cette hétérostructure symétrique lorsque le dispositif est polarisé, et
- les figures 7 à 9 illustrent schématiquement différentes étapes d'un procédé de fabrication d'un tel dispositif.

Dans un premier mode de réalisation particulier, le dispositif comprend une hétérostructure asymétrique formée sur un substrat.

Ce substrat peut être fait d'un matériau semiconducteur mais pourrait tout aussi bien être fait d'un matériau électriquement isolant tel que le verre.

L'hétérostructure asymétrique comprend deux couches minces électriquement conductrices entre lesquelles est intercalée une couche intermédiaire mince, semiconductrice ou isolante.

Les couches conductrices sont faites de matériaux électriquement conducteurs différents de sorte que la couche intermédiaire forme respectivement avec les deux couches électriquement conductrices des barrières de potentiel de hauteurs différentes.

Les épaisseurs des différentes couches de l'hétérostructure dépendent des matériaux utilisés pour former ces couches et peuvent être de l'ordre de quelques nanomètres à quelques centaines de nanomètres pour les deux couches minces conductrices et de quelques nanomètres à quelques centaines de nanomètres pour la couche mince intermédiaire.

Les figures 2 et 3 représentent un diagramme de bande simplifié de l'hétérostructure asymétrique, qui permet de mieux comprendre le principe de variation du seuil de détection du dispositif conforme à l'invention, dont fait partie cette hétérostructure asymétrique.

La première couche conductrice de l'hétérostructure asymétrique porte la référence 6 et forme avec la couche intermédiaire 8 une barrière de potentiel de hauteur phi1.

La deuxième couche conductrice de l'hétérostructure porte la référence 10 et forme avec la couche intermédiaire 8 une barrière de potentiel de hauteur phi2.

On suppose que les matériaux constitutifs des couches 6 et 10 sont choisis de façon que phi1 soit inférieur à phi2.

De plus, ces matériaux sont choisis de façon à pouvoir explorer avec le dispositif comportant les couches 6, 8 et 10, le domaine de longueurs d'onde optiques que l'on souhaite.

En l'absence de polarisation du dispositif (figure 2), c'est-à-dire lorsqu'aucune tension n'est appliquée entre les deux couches conductrices 6 et 10, ces deux couches conductrices 6 et 10 ont le même niveau de FERMI qui porte la référence EF sur les figures 2 et 3.

En exposant la couche 6 à un rayonnement lumineux d'énergie h.f, un électron de cette couche 6, qui est photo-excité par ce rayonnement, doit franchir une barrière de potentiel de forme trapézoidale ou, plus précisément, doit franchir successivement les deux barrières de potentiel phi1 et phi2, pour être collecté par la couche conductrice 10.

Le seuil de détection est donc, dans ce cas, égal à la plus haute des deux barrières de potentiel, en l'occurrence phi2.

L'application d'une tension électrique entre les deux couches conductrices 6 et 10 permet de modifier la barrière de potentiel qui existe entre ces deux couches conductrices (figure 3).

En prenant la couche conductrice 10 comme référence, une polarisation négative de la couche 6 par rapport à cette couche 10 entraîne, sur le diagramme de la figure 3, un déplacement des niveaux d'énergie vers le haut de cette figure 3 et permet de rapprocher les niveaux supérieurs respectifs S1 et S2 des barrières de potentiel phi1 et phi2 et donc de diminuer le seuil de détection optique.

Dans ce cas, un électron photo-excité de la couche conductrice 6 n'a plus qu'à franchir une barrière de potentiel dont la hauteur est égale à :

$$phi2 - |e|.|V|$$

où |e| représente la valeur absolue de la charge d'un électron et |V| représente la valeur absolue de la tension appliquée entre les deux couches conductrices (en comptant phi1 et phi2 positivement).

On voit donc que le seuil de photodétection varie de façon linéaire avec la tension appliquée au dispositif.

La variation du seuil de détection peut être très importante (elle peut être de l'ordre de plusieurs centaines de meV) et elle est obtenue par application d'une tension électrique faible entre les deux couches conductrices, cette tension étant égale à la variation du seuil de détection divisée par la charge d'un électron.

La possibilité d'utiliser une faible tension pour faire varier le seuil de détection permet de limiter fortement le courant de fuite du dispositif et donc de faciliter la détection du photocourant résultant de l'arrivée du rayonnement sur le dispositif, ce qui conduit à un bon rapport signal/bruit.

A titre d'exemple, on souhaite explorer le domaine des rayonnenents dont les énergies vont de 0,3eV à 0,65 eV.

A cet effet, on utilise par exemple une couche intermédiaire en silicium et deux couches conductrices dont l'une est en disiliciure d'erbium, ce qui conduit à une barrière de potentiel de 0,3eV par rapport à la bande de conduction de la couche intermédiaire en siliciun, et l'autre en disiliciure de cobalt, ce qui conduit à une barrière de potentiel de 0,65eV par rapport à la bande de conduction de cette couche de silicium.

Sans polarisation, on détecte ainsi des photons dont l'énergie est au moins égale à 0,65 eV (phi2) et, en appliquant une tension suffisante entre les deux couches conductrices, les niveaux supérieurs S1 et S2 des barrières de potentiel phi1 et phi2 peuvent être rendus égaux, ce qui permet de détecter des photons dont l'énergie est au moins égale à 0,3 eV (phi1).

On peut donc choisir le seuil de détection entre 0,3 eV et 0,65 eV.

On notera qu'en polarisant positivement la couche 6 par rapport à la couche 10 prise comme référence de tension, on peut augmenter la limite supérieure du domaine exploré en allant donc au delà de 0,65 eV.

Sur la figure 4, on a représenté schématiquenent un dispositif approprié à l'invention.

Ce dispositif comprend l'hétérostructure composée des couches 6, 8 et 10 et formée sur une face d'un substrat 12, qui est appelée face supérieure.

Suivant les applications envisagées pour le dispositif, on est amené à exposer ce dispositif aux rayonnements de façon que ces rayonnements arrivent soit sur la face supérieure du substrat soit sur la face inférieure du substrat.

Dans ce dernier cas, il faut que ce substrat soit au moins partiellement transparent dans la gamme de longueurs d'onde optiques que l'on veut étudier.

Par exemple, dans le cas de rayonnements infrarouges, on peut alors prendre un substrat en silicium.

Sur la figure 4, on voit également des contacts électriques 14 à 16 respectivement placés sur les couches 6 et 10 (la couche conductrice la plus proche du substrat dépassant de l'empilement des couches) ainsi que des moyens 18 permettant d'appliquer une tension électrique variable entre les contacts 14 et 16 et donc entre les couches conductrices 6 et 10.

On peut ainsi explorer le domaine de longueurs d'onde optiques souhaité en faisant varier la tension appliquée entre les contacts.

On voit aussi sur la figure 4 des moyens électroniques 20 de mesure et de traitement du photo-courant que l'on obtient par éclairement du dispositif.

Ces moyens électroniques 20 sont également reliés aux contacts électriques 14 et 16.

Bien entendu, les épaisseurs des deux couches conductrices et de la couche semiconductrice sont calculées pour maximiser l'absorption et le rendement de fonctionnement du dispositif, ceci étant valable tant pour un dispositif à hétérostructure asymétrique que pour un dispositif à hétérostructure symétrique que l'on considère dans ce qui suit.

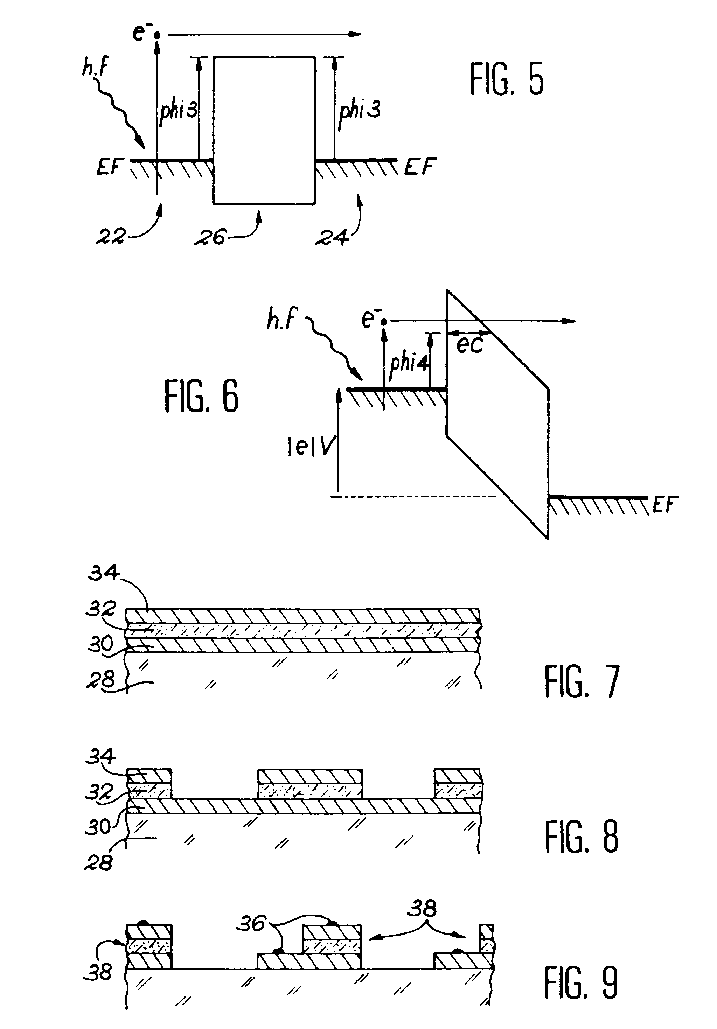

Les figures 5 et 6 illustrent schématiquement le principe d'un autre dispositif approprié à l'invention.

Dans cet autre dispositif, on utilise non plus une hétérostructure asymétrique mais une hétérostructure symétrique.

Cette hétérostructure symétrique comprend deux couches électriquement conductrices 22 et 24 entre lesquelles se trouve une couche intermédiaire semiconductrice ou isolante 26, les deux couches 22 et 24 formant respectivement des barrières de potentiel de même hauteur phi3 avec la couche semiconductrice 26.

On voit sur la figure 5 que, en l'absence de polarisation électrique d'une couche par rapport à l'autre, le seuil de détection est égal à phi3.

En polarisant négativement et de façon suffisamment forte l'une des couches conductrices par rapport à l'autre, par exemple la couche 22 par rapport à la couche 24 (qui sont par exemple faites du même matériau électriquement conducteur), on voit, sur la figure 6, que l'on aboutit à un amincissement important de la barrière de potentiel qui existe entre les couches 22 et 24, au voisinage du maximum de cette barrière.

De ce fait, des électrons photo-excités, dont l'énergie n'est pas suffisante pour surmonter cette barrière de potentiel, vont cependant pouvoir franchir celle-ci par effet tunnel.

La hauteur effective de cette barrière de potentiel est donc abaissée, ce qui entraine, là encore, un déplacement du seuil de détection.

On voit sur la figure 6 que la hauteur effective phi4 de la barrière de potentiel, hauteur qui correspond à l'épaisseur critique ec de cette barrière, épaisseur à partir de laquelle l'effet tunnel devient non négligeable, varie en fonction de la tension V appliquée entre les couches conductrices 22 et 24.

On notera que la probabilité pour qu'un électron franchisse une barrière de potentiel par effet tunnel est une fonction très fortement dépendante de l'épaisseur de cette barrière et que cette probabilité devient très faible lorsque cette épaisseur dépasse 10 nanomètres.

Comme précédemment, suivant les applications envisagées pour ce dispositif à hétérostructure symétrique, le substrat qu'il comporte peut être transparent ou partiellement transparent ou opaque au rayonnement étudié.

Ce dispositif des figures 5 et 6 est muni de moyens (non représentés) permettant d'appliquer une tension électrique entre les couches conductrices 22 et 24 et de faire varier cette tension, et de moyens électroniques (non représentés) de mesure et de traitement du photocourant obtenu par éclairement du dispositif.

On notera que l'on pourrait également faire varier le seuil de détection optique d'un dispositif à hétérostructure asymétrique en utilisant l'effet tunnel et en appliquant des tensions électriques suffisamment élevées entre les deux couches conductrices de ce dispositif pour amincir de façon importante la barrière de potentiel entre ces deux couches, au voisinage du maximum de cette barrière.

On indique ci-après comment réaliser un dispositif approprié à l'invention.

L'exemple de procédé de fabrication que l'on va donner utilise des technologies de croissance en ultravide.

Pour réaliser un dispositif approprié à l'invention, on procède par exemple de la façon suivante :

1°) on forme par épitaxie sur un substrat 28 (figure 7) en silicium monocristallin, une couche métallique mince 30 de disiliciure d'erbium (Ersi$_2$), par co-dépôt stoechiométrique, suivi d'un recuit de recristallisation ;

2°) on forme sur la couche mince 30, par épitaxie par jets moléculaires ou par dépôt chimique en phase vapeur, une couche mince semiconductrice 32 de silicium ;

3°) on forme par épitaxie, sur la couche 32, une couche métallique mince 34 de disiliciure de cobalt CoSi$_2$, par co-dépôt stoechiométrique, suivi d'un recuit de cristallisation ; en variante la couche 34 pourrait être une couche de platine, de chrome ou d'iridium, formée par évaporation sous vide ;

4°) on définit le niveau métallique supérieur du dispositif par des techniques classiques de photolithographie : la couche 34 est gravée par une solution d'acide fluorhydrique dilué et la couche de silicium est gravée par une solution de potasse diluée, la couche de CoSi$_2$ jouant alors le rôle de masque ; cette gravure chimique s'arrête à la couche inférieure en ErSi$_2$ qui n'est pas attaquée par la potasse (figure 8);

5°) on définit le niveau métallique inférieur du dispositif par une nouvelle lithographie (figure 9) et, pour ce faire, on grave la couche en ErSi$_2$ au moyen d'une solution à base d'acide fluorydrique dilué ; une légère surgravure du silicium du substrat 28 peut être obtenue par gravure dans une solution de potasse diluée ;

6°) on forme des contacts électriques 36 sur chaque couche métallique de chaque dispositif 38 que l'on a défini par lithographie comme on l'a expliqué plus haut, ces contacts électriques étant par exemple formés par une technique de soudure par thermocompression et permettant non seulement de polariser (de façon variable, par des moyens non représentés) chaque dispositif 38 mais encore de détecter le photocourant produit par chacun de ces dispositifs.

On obtient ainsi des dispositifs à hétérostructure asymétrique.

Pour former des dispositifs à hétérostructure symétrique, il suffirait de former des couches 30 et 34 identiques.

On notera que la réalisation des dispositifs de détection 38 sur un substrat en silicium permet de fabriquer sur ce même substrat des circuits électroniques de commande de ces dispositifs 38 et/ou des circuits électroniques d'amplification des photo-courants produit par ces dispositifs 38.

Par ailleurs, suivant les applications envisagées, les dispositifs 38 obtenus peuvent être séparés les uns des autres par des techniques classiques ou, au contraire, non séparés si l'on souhaite utiliser une matrice de dispositifs de détection.

Dans l'exemple qui précède, on peut remplacer l'une (ou les deux) couche(s) métallique(s) de l'hétérostructure par une (ou deux) couche(s) semiconductrice (s) suffisamment dopée(s) par exemple un alliage de silicium et de germaniun fortement dopé avec du bore.

Avec la présente invention, il est par exemple possible de fabriquer une caméra capable de fonctionner à diverses longueurs d'onde, alors que dans l'art antérieur il fallait autant de caméras ou de filtres que de longueurs d'onde à étudier.

## Revendications

1. Procédé de détection optique, utilisant un dispositif comportant un substrat (12, 28) et, sur ce substrat, au moins un élément (38) comportant une hétérostructure, cette hétérostructure comprenant deux couches électriquement conductrices (6-10, 22-24, 30-34) et, entre ces dernières, une couche semiconductrice (8, 26, 32) ou isolante formant une barrière de potentiel avec chacune des couches conductrices, selon lequel on forme des électrons excités en éclairant l'hétérostructure par un rayonnement lumineux dont l'énergie est au moins égale au seuil de détection de l'hétérostructure, ce qui permet de détecter ce rayonnement par photo-émission interne des électrons d'une couche conductrice à l'autre, ledit procédé étant caractérisé en ce qu'on applique une polarisation variable à l'hétérostructure, de façon à faire varier le spectre, et également le seuil, de détection du dispositif.

2. Procédé selon la revendication 1, caractérisé en ce que les couches conductrices (6-10) sont choisies de façon que les hauteurs des barrières de potentiel qui leur correspondent soient différentes l'une de l'autre.

3. Procédé selon la revendication 1, caractérisé en ce que les couches conductrices (22, 24) sont choisies de façon que les hauteurs des barrières de potentiel qui leur correspondent soient sensiblement égales l'une à l'autre.

4. Procédé selon l'une quelconque des revendications 2 et 3, caractérisé en ce que le substrat (12) est opaque au rayonnement.

5. Procédé selon l'une quelconque des revendications 2 et 3, caractérisé en ce que le substrat (28) est au moins partiellement transparent au rayonnement.

6. Procédé selon l'une quelconque des revendications 1 à 5, caractérisé en ce que le substrat (28) est en silicium.

7. Procédé selon la revendication 1, caractérisé en ce que les deux couches conductrices (30, 34) sont respectivement en disiliciure d'erbium et en disiliciure de cobalt, en ce que la couche intermédiaire (32) est en silicium et en ce que le substrat (28) est également en silicium.

## Patentansprüche

1. Optisches Detektierverfahren unter Verwendung einer Vorrichtung, die ein Substrat (12, 28) und auf dem Substrat mindestens ein eine Heterostruktur aufweisendes Element (38) besitzt, wobei diese Heterostruktur zwei elektrisch leitende Schichten (6-10, 22-24, 30-34) und zwischen diesen eine Halbleiterschicht (8, 26, 32) oder Isolierschicht besitzt, welche eine Potentialbarriere mit jeder der leitenden Schichten bildet, wobei man dadurch angeregte Elektronen bildet, daß man die Heterostruktur mit Lichstrahlung beleuchtet, deren Energie mindestens der Detektierschwelle der Heterostruktur entspricht, was es ermöglicht, diese Strahlung durch innere Photoemission von Elektronen aus der einen leitenden Schicht in die andere nachzuweisen, wobei das Verfahren **dadurch gekennzeichnet** ist, daß man an die Heterostruktur eine veränderliche Vorspannung anlegt, um das dem Schwellenwert entsprechende Detektierspektrum der Vorrichtung zu variieren.

2. Verfahren nach Anspruch 1, **dadurch gekennzeichnet**, daß die leitenden Schichten (6-10) derart gewählt sind, daß die Höhen der ihnen entsprechenden Potentialbarrieren sich voneinander unterscheiden.

3. Verfahren nach Anspruch 1, **dadurch gekennzeichnet**, daß die leitenden Schichten (22, 24) derart gewählt sind, daß die Höhen der ihnen entsprechenden Potentialbarrieren einander im wesentlichen gleichen.

4. Verfahren nach einem der Ansprüche 2 und 3, **dadurch gekennzeichnet**, daß das Substrat (12) für die Strahlung opak ist.

5. Verfahren nach einem der Ansprüche 2 und 3, **dadurch gekennzeichnet**, daß das Substrat (28) für die Strahlung zumindest teilweise transparent ist.

6. Verfahren nach einem der Ansprüche 1 bis 5, **dadurch gekennzeichnet**, daß das Substrat (28) aus Silizium besteht.

7. Verfahren nach Anspruch 1, **dadurch gekennzeichnet**, daß die zwei leitenden Schichten (30, 34) Erbium-Disilizid bzw. Kobalt-Disilizid sind, daß die Zwischenschicht (32) aus Silizium besteht, und daß das Substrat (28) ebenfalls aus Silizium besteht.

## Claims

1. Optical detection process, using a device having a substrate (12, 28) and, on said substrate, at least one element (38) having a heterostructure, said heterostructure incorporating two electrically conducting layers (6-10, 22-24, 30-34) and, between the latter a semiconducting or insulating layer (8, 26, 32) forming a potential barrier with each of the conducting layers according to which excited electrons are formed by illuminating when the heterostructure by light radiation, whose energy is at least equal to the detection threshold of the heterostructure, which makes it possible to detect said radiation by internal photoemission of the electrons from one conducting layer to the other, said process being characterized in that a variable polarization is applied to the heterostructure so as to vary the detection spectrum and also the detection threshold of the device.

2. Process according to claim 1, characterized in that the conducting layers (6-10) are chosen in such a way that the heights of the corresponding potential barriers differ from one another.

3. Process according to claim 1, characterized in that the conducting layers (22, 24) are chosen in such a way that the heights of the corresponding potential barriers are substantially equal to one another.

4. Process according to either of the claims 2 and 3, characterized in that the substrate (12) is opaque to the radiation.

5. Process according to either of the claims 2 and 3, characterized in that the substrate (28) is at least partly transparent to the radiation.

6. Process according to any one of the claims 1 to 5, characterized in that the substrate (28) is of silicon.

7. Process according to claim 1, characterized in that the two conducting layers (30, 34) are respectively of erbium disilicide and cobalt disilicide, that the intermediate layer (32) is of silicon and that the substrate (28) is also of silicon.

FIG. 1

FIG. 2

FIG. 3

FIG. 4

FIG. 5

FIG. 6

FIG. 7

FIG. 8

FIG. 9